# EUROPEAN PATENT APPLICATION

(11) **EP 4 817 871 A1**
(43) Date of publication of application: **07.10.2026**
(21) Application number: 24897428.9
(22) Date of filing: 21.11.2024
(51) Int. Cl.: B32B 27/00, C09J 7/30, H05K 1/03, H05K 1/16, H05K 3/46

(54) **RESIN FILM, MULTILAYER WIRING BOARD, COPPER FOIL WITH RESIN, COIL STRUCTURE, AND MAGNETIC DEVICE**

(30) Priority: 30.11.2023 JP 2023202853
(71) Applicant: Tamura Corporation, Tokyo 178-8511 (JP)
(72) Inventor: EINISHI, Hiro, Iruma-shi, Saitama 358-8501 (JP); KATO, Aoto, Iruma-shi, Saitama 358-8501 (JP); TANAHASHI, Yusuke, Iruma-shi, Saitama 358-8501 (JP); TANIGUCHI, Hiroaki, Iruma-shi, Saitama 358-8501 (JP); KIYOTA, Tatsuya, Tokyo 178-8511 (JP); AOKI, Hirotoshi, Sakado-shi, Saitama 350-0214 (JP); SAITO, Shoichi, Tokyo 178-8511 (JP)
(74) Representative: Grünecker Patent- und Rechtsanwälte PartG mbB
(86) International application number: PCT/JP2024/041224
(87) International publication number: WO 2025/115742

(57) **Abstract**

A resin film (100) includes: a core layer (2); and adhesive resin layers (1) respectively provided on both surfaces of the core layer (2), in which the adhesive resin layers (1) include an adhesive resin composition, and a minimum viscosity of the adhesive resin composition, as measured with a rheometer, over a temperature range of 40 degrees Celsius to 160 degrees Celsius is 500 Pa·s or more.

## Description

### TECHNICAL FIELD

The present invention relates to a resin film, a multilayer wiring board, a copper foil with resin, a coil structure, and a magnetic device.

### BACKGROUND ART

As one of magnetic devices, a thin transformer is known. For example, Patent Literature 1 describes a thin transformer including: a printed coil; a core including a magnetic material; and a terminal-equipped base on which the printed coil and the core are mounted. This thin transformer is characterized in that a surface on which a conductor of the printed coil is exposed is covered with a heat-resistant resin.

### CITATION LIST

### PATENT LITERATURE(S)

Patent Literature 1: JPH09-326316 A

### SUMMARY OF THE INVENTION

### PROBLEM(S) TO BE SOLVED BY THE INVENTION

However, in recent years, magnetic devices have been required to allow a higher voltage and a larger current to be applied. Therefore, in order to reliably ensure the insulating properties of a heat-resistant resin layer, it may be considered to use, for example, an interlayer insulating material having a three-layer structure including a core layer and adhesive resin layers respectively provided on both surfaces of the core layer. However, it has been found that, when a reflow treatment is performed on a multilayer wiring board using such an interlayer insulating material, interlayer delamination may occur.

An object of the invention is to provide a resin film capable of preventing occurrence of interlayer delamination even when subjected to a high-temperature heat treatment, and also to provide a multilayer wiring board, a copper foil with resin, a coil structure, and a magnetic device using the resin film.

### MEANS FOR SOLVING THE PROBLEM(S)

According to aspects of the invention, there are provided a resin film, a multilayer wiring board, a copper foil with resin, a coil structure, and a magnetic device as below.
[1] A resin film including: a core layer; and adhesive resin layers respectively provided on both surfaces of the core layer, in which the adhesive resin layers include an adhesive resin composition, and a minimum viscosity of the adhesive resin composition, as measured with a rheometer, over a temperature range of 40 degrees Celsius to 160 degrees Celsius is 500 Pa·s or more.
[2] The resin film according to [1], in which the adhesive resin composition contains an epoxy resin, an aromatic amine-based curing agent, and a solvent-soluble polyimide resin.
[3] The resin film according to [1] or [2], in which the core layer is formed of a polyimide film.
[4] The resin film according to any one of [1] to [3], in which a viscosity of the adhesive resin composition, as measured with a rheometer, at a temperature of 60 degrees Celsius is 5×10⁵ Pa·s or more.
[5] A multilayer wiring board including an insulating layer formed using the resin film according to any one of [1] to [4].
[6] A copper foil with resin including: the resin film according to any one of [1] to [4]; and a copper foil laminated on the resin film.
[7] A coil structure including an insulating layer formed using the resin film according to any one of [1] to [4].
[8] A magnetic device including an insulating layer formed using the resin film according to any one of [1] to [4].

According to the aspects of the invention, it is possible to provide a resin film capable of preventing occurrence of interlayer delamination even when subjected to a high-temperature heat treatment, and also to provide a multilayer wiring board, a copper foil with resin, a coil structure, and a magnetic device using the resin film.

### BRIEF DESCRIPTION OF DRAWINGS

Fig. 1 schematically illustrates a resin film according to an exemplary embodiment of the invention.
Fig. 2A is an explanatory view illustrating an example of a method for producing the resin film according to the exemplary embodiment of the invention.
Fig. 2B is another explanatory view illustrating the example of the method for producing the resin film according to the exemplary embodiment of the invention.
Fig. 2C is still another explanatory view illustrating the example of the method for producing the resin film according to the exemplary embodiment of the invention.
Fig. 3A is an explanatory view illustrating an example of a method for producing a multilayer wiring board according to the exemplary embodiment of the invention.
Fig. 3B is another explanatory view illustrating the example of the method for producing the multilayer wiring board according to the exemplary embodiment of the invention.
Fig. 3C is still another explanatory view illustrating the example of the method for producing the multilayer wiring board according to the exemplary embodiment of the invention.
Fig. 4 is a graph showing results of measurement, with a rheometer, of viscosity over a temperature range of 40 degrees Celsius to 170 degrees Celsius for adhesive resin compositions of resin films obtained in Example 1 and Comparative Example 1.

### DESCRIPTION OF EMBODIMENT(S)

Hereinafter, the invention will be described by way of an embodiment with reference to the drawings. The invention is not limited to the exemplary embodiment. In the drawings, some portions are illustrated in an enlarged or reduced manner for ease of explanation.

### Resin Film

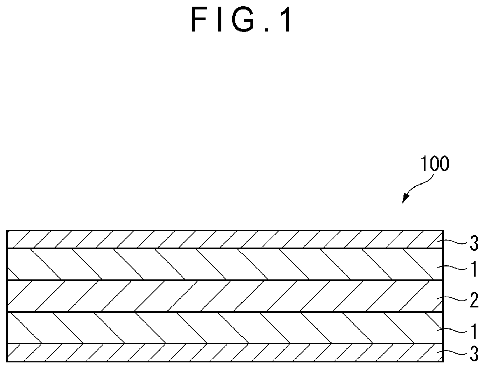

As illustrated in Fig. 1, a resin film 100 according to the exemplary embodiment includes a core layer 2, adhesive resin layers 1, and release film layers 3. The adhesive resin layers 1 are respectively provided on both surfaces of the core layer 2. The release film layers 3 are provided on the respective adhesive resin layers 1. When the resin film 100 is used, the release film layers 3 are peeled from the adhesive resin layers 1 before use.

The adhesive resin layer 1 includes an adhesive resin composition. It is necessary that the adhesive resin composition have a minimum viscosity of 500 Pa·s or more in a temperature range of 40 to 160 degrees Celsius, as measured with a rheometer.

The reason why the resin film 100 according to the exemplary embodiment can prevent the occurrence of interlayer delamination even when subjected to a high-temperature heat treatment is as follows.

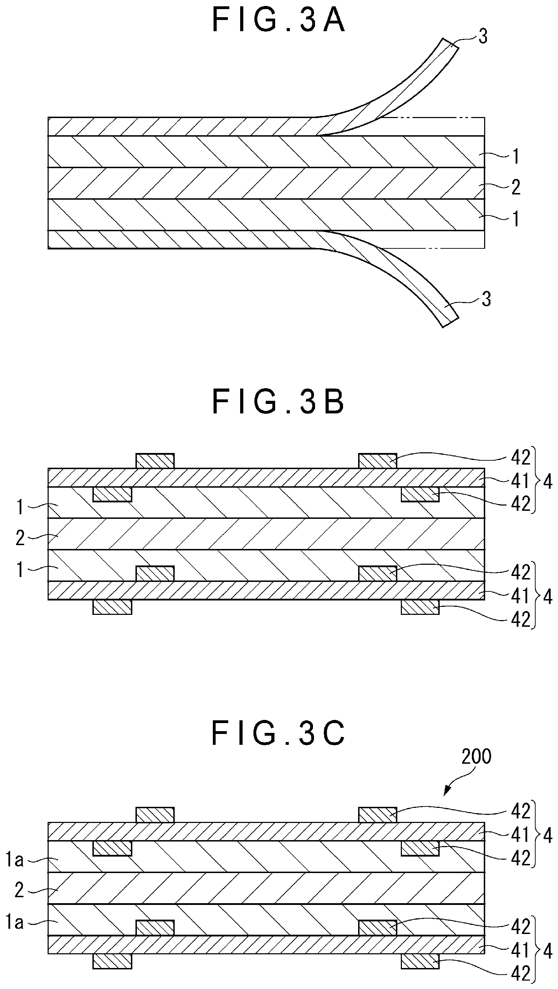

That is, the inventors presumed that, when a multilayer wiring board 200 (see Fig. 3C) is produced using the resin film 100, the occurrence of interlayer delamination is affected by a change in viscosity of the adhesive resin composition during curing. The adhesive resin composition becomes softer as the temperature increases, but also becomes harder as the adhesive resin composition is cured by heat. The inventors found that interlayer delamination occurs when the minimum viscosity during this process is excessively low. As a result of intensive studies, the inventors found that the occurrence of interlayer delamination can be prevented by using an adhesive resin composition having a minimum viscosity of 500 Pa·s or more in a temperature range of 40 to 160 degrees Celsius, as measured with a rheometer.

The minimum viscosity in a temperature range of 40 to 160 degrees Celsius is preferably 1,000 Pa·s or less, and particularly preferably 800 Pa·s or less. When the minimum viscosity is equal to or less than the above upper limit, adhesiveness and the like of the adhesive resin composition can be improved.

From the same viewpoint, the temperature at which the minimum viscosity is exhibited is preferably 130 degrees Celsius or more and 150 degrees Celsius or less, and more preferably 135 degrees Celsius or more and 145 degrees Celsius or less.

The viscosity at a temperature of 60 degrees Celsius is preferably 5×10⁵ Pa·s or more and 5×10⁶ Pa·s or less, and particularly preferably 1×10⁶ Pa·s or more and 3×10⁶ Pa·s or less. When this viscosity is equal to or more than the above lower limit, the occurrence of interlayer delamination can be more reliably prevented.

The viscosity of the adhesive resin layer 1 can be measured as follows. Specifically, first, the adhesive resin composition of the adhesive resin layer 1 is collected from the resin film 100 as a sample. The collected adhesive resin composition is introduced into a rheometer (device name: "HAAKE MARS III", produced by Thermo Fisher Scientific), and the viscosity of the adhesive resin composition is measured while the temperature is changed from 40 degrees Celsius to 160 degrees Celsius at a rate of temperature increase of 2.5 degrees Celsius/min and a frequency of 1.0 Hz, with the plate being rotationally oscillated.

Examples of methods for adjusting the minimum viscosity, the degree of change in viscosity, and the like of the adhesive resin composition to the above-described ranges include the following.

The minimum viscosity, the degree of change in viscosity, and the like can be adjusted by changing the type or blending amount of a resin and a curing agent, or by changing the degree to which the adhesive resin composition is B-staged (semicured).

### Adhesive Resin Layer

The adhesive resin layer 1 includes an adhesive resin composition. The adhesive resin layer 1 may be formed by applying a coating liquid for an adhesive resin composition and drying the coating liquid. The adhesive resin composition may also be B-staged by heat.

The coating liquid for the adhesive resin composition preferably contains an epoxy resin, an aromatic amine-based curing agent, and a solvent-soluble polyimide resin. By B-staging the adhesive resin composition, the minimum viscosity can be easily adjusted within the above-described range.

The coating liquid for the adhesive resin composition may optionally contain a filler, a curing accelerator, a flame retardant, a solvent, and the like.

As the epoxy resin, any epoxy resin having two or more glycidyl groups can be used. Preferred examples of the epoxy resin include bisphenol A-type epoxy resins, bisphenol F-type epoxy resins, novolac phenol-type epoxy resins, biphenyl-type epoxy resins, naphthalene-type epoxy resins, and dicyclopentadiene-type epoxy resins. These may be used alone, or two or more thereof may be used in combination.

The aromatic amine-based curing agent is not particularly limited as long as it has an aromatic group and an amino group and has an action of accelerating curing of the epoxy resin upon light irradiation. Examples of the aromatic group include a phenyl group, a biphenyl group, and a fluorenyl group. Examples of the aromatic amine-based curing agent include 4,4'-diaminodiphenyl sulfone, 4,4'-bis(4-aminophenoxy)biphenyl, 2,2-bis[4-(4-aminophenoxy)phenyl]propane, bis[4-(4-aminophenoxy)phenyl]sulfone, 1,3-bis(4-aminophenoxy)benzene, 1,4-bis(4-aminophenoxy)benzene, trimethylene bis(4-aminobenzoate), 3,3'-dimethyl-4,4'-diaminobiphenyl, 2,2'-dimethyl-4,4'-diaminobiphenyl, 4,4'-diaminodiphenyl ether, 3,4'-diaminodiphenyl ether, bis[4-(3-aminophenoxy)phenyl]sulfone, 9,9'-bis(4-aminophenyl)fluorene, and 2,2-bis[4-(4-aminophenoxy)phenyl]hexafluoropropane. These may be used alone, or two or more thereof may be used in combination.

When the number of moles of the epoxy resin is taken as 1, the amount of the aromatic amine-based curing agent used is preferably 0.3 mol or more and 1.5 mol or less. When the amount used is equal to or more than the above lower limit, a desired coefficient of thermal expansion tends to be more easily obtained. When the amount used is equal to or less than the above upper limit, a desired Tg and coefficient of thermal expansion tend to be more easily obtained.

The solvent-soluble polyimide resin is a polyimide resin that is soluble in a solvent used for producing the adhesive resin composition according to the exemplary embodiment. The solvent-soluble polyimide resin preferably has properties of a high Tg, a low coefficient of thermal expansion, excellent film physical properties, a low dielectric constant, and a low dielectric loss tangent. Examples of the solvent-soluble polyimide resin include fully imidized soluble polyimide resins obtained by reacting diaminotrimethylphenylindane with benzophenonetetracarboxylic dianhydride. This compound can improve adhesive strength without using any other adhesion-imparting agent in combination therewith.

The number-average molecular weight (Mn) of the solvent-soluble polyimide resin is not particularly limited, but is preferably 10,000 or more and 50,000 or less, and particularly preferably 12,000 or more and 20,000 or less.

When the total amount of the epoxy resin and the aromatic amine-based curing agent is taken as 100 parts by mass, the blending amount of the solvent-soluble polyimide resin is preferably 10 parts by mass or more and 100 parts by mass or less, and particularly preferably 15 parts by mass or more and 100 parts by mass or less. When the blending amount is equal to or more than the above lower limit, the effect of improving adhesive strength and flexibility tends to be more easily obtained. When the blending amount is equal to or less than the above upper limit, the tensile strength at break of the film tends to be ensured.

Examples of the filler include silica, alumina, aluminum hydroxide, and magnesium hydroxide. These may be used alone, or two or more thereof may be used in combination.

Examples of the curing accelerator include imidazoles. These may be used alone, or two or more thereof may be used in combination.

Examples of the flame retardant include condensed phosphate esters, phosphazenes, polyphosphates, and HCA (9,10-dihydro-9-oxa-10-phosphaphenanthrene-10-oxide) derivatives. These may be used alone, or two or more thereof may be used in combination.

Examples of the solvent include N-methylpyrrolidone (NMP), diethylene glycol monomethyl ether acetate, cyclohexanone, and methyl ethyl ketone (MEK). These may be used alone, or two or more thereof may be used in combination.

The thickness of the adhesive resin layer 1 varies depending on the copper thickness of a wiring board to be laminated, and is not particularly limited. For example, when the copper thickness of the wiring board is 35 µm, the thickness of the adhesive resin layer 1 is preferably 5 µm or more and 100 µm or less, more preferably 10 µm or more and 70 µm or less, still more preferably 20 µm or more and 50 µm or less, and particularly preferably 30 µm or more and 40 µm or less. When the thickness is equal to or less than the above upper limit, the thickness of the resin film 100 can be made smaller. When the thickness is equal to or more than the above lower limit, the adhesiveness of the resin film 100 can be improved.

### Core Layer

The core layer 2 is a layer serving as a core located at the center of the three-layer resin film 100. The core layer 2 prevents occurrence of resin outflow and the like during thermocompression bonding when a multilayer wiring board or the like is produced using the resin film 100.

Preferably, the core layer 2 is formed of a resin film having excellent heat resistance. Examples of such a film include polyimide films, polyetherimide films, polyamide films, polyamide-imide films, polymethylpentene films, polyester films, polyether ether ketone films, liquid crystal polymer films, polyphenylene ether films, polyphenylene sulfide films, polyolefin films, syndiotactic polystyrene-based films, fluororesin films, and cycloolefin polymer films. Among these, polyimide films are preferred from the viewpoint of having good compatibility with the adhesive resin layer 1.

The thickness of the core layer 2 varies depending on the configuration of a wiring board to be laminated, and is not particularly limited. For example, the thickness of the core layer 2 is preferably 5 µm or more and 100 µm or less, more preferably 10 µm or more and 50 µm or less, and particularly preferably 20 µm or more and 30 µm or less. When the thickness is equal to or less than the above upper limit, the thickness of the resin film 100 can be made smaller. When the thickness is equal to or more than the above lower limit, the insulating properties of the resin film 100 can be improved.

### Release Film Layer

The release film layer 3 is a layer formed of a release film and provided on the adhesive resin layer 1. When the resin film 100 is used, the release film layer 3 can be peeled from the adhesive resin layer 1 before use. In addition, the adhesive resin layer 1 can be easily formed because a coating liquid for the adhesive resin composition can be applied onto the release film layer 3 to form a film, and the film can be B-staged. The release film layer 3 is not necessarily provided. The release film layer 3 is a member provided as necessary.

Examples of the release film include polyethylene terephthalate films (PET films) and polyethylene naphthalate films. A release treatment may be applied to a surface of the release film.

### Method for Producing Resin Film

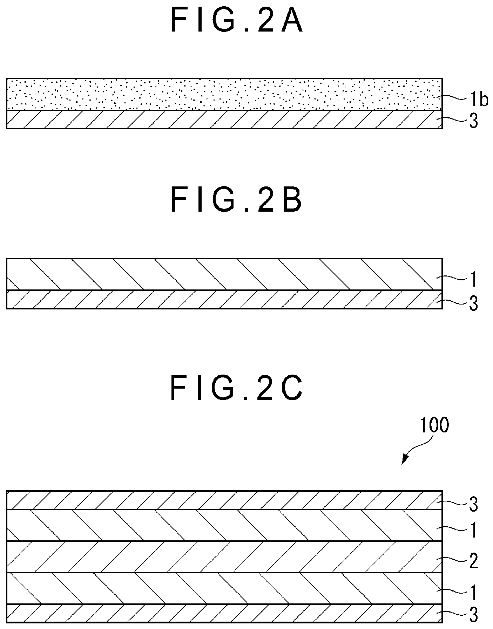

A method for producing the resin film 100 according to the exemplary embodiment is not particularly limited. For example, as illustrated in Figs. 2A to 2C, the resin film 100 can be produced by a method including: a film-forming step of applying a coating liquid for the adhesive resin composition onto the release film layer 3 to form a coating film 1b; a drying step of drying the coating film 1b formed in the film-forming step to form the adhesive resin layer 1 and obtain an adhesive laminated film; and a laminating step of sandwiching the core layer 2 between two adhesive laminated films obtained in the drying step and laminating them to obtain the resin film 100.

In the film-forming step, as illustrated in Fig. 2A, the coating liquid for the adhesive resin composition is applied onto the release film layer 3 to form a film.

Examples of the apparatus for applying the adhesive resin composition include bar coaters, curtain coaters, spray coaters, roll coaters, and screen printing machines.

The coating thickness of the adhesive resin composition is preferably adjusted such that the thickness of the adhesive resin layer 1 falls within the above-described range.

In the drying step, as illustrated in Fig. 2B, the coating film 1b formed in the film-forming step is dried to form the adhesive resin layer 1, thereby obtaining an adhesive laminated film.

The drying temperature is preferably 100 degrees Celsius or more and 160 degrees Celsius or less, more preferably 105 degrees Celsius or more and 155 degrees Celsius or less, and particularly preferably 110 degrees Celsius or more and 150 degrees Celsius or less. When the temperature is within the above range, the adhesive resin composition can be appropriately B-staged, and the minimum viscosity of the adhesive resin composition can be adjusted to a suitable range.

The drying time is preferably 10 seconds or more and 600 seconds or less, more preferably 15 seconds or more and 500 seconds or less, and particularly preferably 30 seconds or more and 500 seconds or less. When the time is within the above range, the adhesive resin composition can be appropriately B-staged, and the minimum viscosity of the adhesive resin composition can be adjusted to a suitable range.

In the laminating step, as illustrated in Fig. 2C, the core layer 2 is sandwiched between the two adhesive laminated films obtained in the drying step, and the resulting assembly is laminated, thereby obtaining the resin film 100.

Here, the core layer 2 is sandwiched between the two adhesive laminated films such that the release film layers 3 of the adhesive laminated films are located on the outer sides. Since the adhesive resin layers 1 have adhesiveness, the adhesive laminated films can be bonded to the core layer 2, thereby obtaining the resin film 100.

As the lamination, vacuum pressure lamination, vacuum roll lamination, roll lamination, or the like can be employed.

In this manner, the resin film 100 according to the exemplary embodiment can be produced.

### Multilayer Wiring Board

The multilayer wiring board 200 according to the exemplary embodiment includes an insulating layer formed using the resin film 100 according to the exemplary embodiment. Although this insulating layer has a three-layer structure, occurrence of interlayer delamination can be prevented even when a high-temperature heat treatment is performed.

For example, as illustrated in Figs. 3A to 3C, the multilayer wiring board 200 can be produced by a method including: a release film removal step of removing the release film layers 3 from the resin film 100; a laminating step of sandwiching the resin film 100 from which the release film layers 3 have been removed between two single-layer wiring boards 4 to obtain a wiring laminate; and a thermosetting step of subjecting the adhesive resin layers 1 of the wiring laminate obtained in the laminating step to a thermosetting treatment to obtain the multilayer wiring board 200.

In the release film removal step, as illustrated in Fig. 3A, the release film layers 3 are removed from the resin film 100.

Each release film layer 3 protects the adhesive resin layer 1 until use, and can be removed by peeling it from the adhesive resin layer 1.

In the laminating step, as illustrated in Fig. 3B, the resin film 100 from which the release film layers 3 have been removed is sandwiched between two single-layer wiring boards 4, thereby obtaining a wiring laminate.

Each single-layer wiring board 4 includes a base material 41 and wirings 42. The single-layer wiring board 4 may be a double-sided board including the wirings 42 on both surfaces, or may be a single-sided board.

Here, the resin film 100 from which the release film layers 3 have been removed is sandwiched between the two single-layer wiring boards 4. Since the adhesive resin layers 1 have adhesiveness, the resin film 100 can be bonded to the two single-layer wiring boards 4, thereby obtaining the wiring laminate.

In the thermosetting step, the adhesive resin layers 1 of the wiring laminate obtained in the laminating step are subjected to a thermosetting treatment, thereby obtaining the multilayer wiring board 200 illustrated in Fig. 3C. The adhesive resin layers 1 are converted by the thermosetting treatment into cured resin layers 1a including a cured product of the adhesive composition.

Examples of the thermosetting treatment include thermocompression bonding treatments and heat treatments. The thermosetting treatment may be a one-stage treatment or a treatment of two or more stages.

The temperature of the thermosetting treatment is preferably 150 degrees Celsius or more and 200 degrees Celsius or less, and particularly preferably 170 degrees Celsius or more and 190 degrees Celsius or less.

The pressure of the thermosetting treatment is preferably 0.1 MPa or more and 10 MPa or less, and particularly preferably 0.5 MPa or more and 4 MPa or less.

The time of the thermosetting treatment is preferably 0.5 hours or more and 4 hours or less, and particularly preferably 1 hour or more and 3 hours or less.

In this manner, the multilayer wiring board 200 according to the exemplary embodiment can be produced. Even when electronic components are mounted on the wirings 42 of the multilayer wiring board 200 and a reflow treatment is performed, occurrence of interlayer delamination can be prevented.

### Copper Foil with Resin

A copper foil with resin according to the exemplary embodiment (not illustrated) includes the resin film 100 according to the exemplary embodiment (with at least one of the release film layers 3 removed), and a copper foil laminated on the resin film 100.

According to the copper foil with resin, another wiring can be built up on the wiring of a wiring board via an insulating layer.

The copper foil may be laminated on one surface of the resin film 100, or may be laminated on both surfaces of the resin film 100.

### Coil Structure and Magnetic Device

A coil structure (not illustrated) according to the exemplary embodiment includes an insulating layer formed using the resin film 100 according to the exemplary embodiment.

The coil structure can be produced by a method similar to that for the multilayer wiring board 200 according to the exemplary embodiment described above. That is, the coil structure can be produced by using, as the single-layer wiring board 4, a wiring board having a coil-shaped wiring.

A magnetic device (not illustrated) according to the exemplary embodiment includes an insulating layer formed using the resin film 100 according to the exemplary embodiment.

The magnetic device can be produced by a method similar to that for the multilayer wiring board 200 according to the exemplary embodiment described above. That is, a coil structure can be produced by using, as the single-layer wiring board 4, a wiring board having a coil-shaped wiring. The magnetic device according to the exemplary embodiment includes the coil structure and a core. As the core, a known core such as ferrite can be used.

### Modifications of Exemplary Embodiment

The invention is not limited to the exemplary embodiment described above, and modifications, improvements, and the like within a range in which the object of the invention can be achieved are included in the invention.

For example, in the above-described exemplary embodiment, the multilayer wiring board 200 is obtained by bonding two single-layer wiring boards 4 using the resin film 100, but the invention is not limited thereto. For example, the multilayer wiring board 200 may include three or more single-layer wiring boards 4. In addition, the multilayer wiring board 200 may further include, as an outermost layer, an FR-4 base material or the like in order to improve strength.

### Examples

Next, the invention will be described in more detail by way of an Example and a Comparative Example, but the invention is not limited in any way by the Example and the Comparative Example.

### Preparation Example 1

A mixture including 453 parts by mass of a bisphenol A-type epoxy resin "EPICLON 850-S" (produced by DIC Corporation, epoxy equivalent: 188), 247 parts by mass of an aromatic amine-based curing agent "BAPP" (produced by Wakayama Seika Kogyo Co., Ltd., 2,2-bis[4-(4-aminophenoxy)phenyl]propane), 1500 parts by weight of a soluble polyimide resin "Q-VR-X0163" (produced by PI R&D Co., Ltd., resin solid content: 20% by mass), and 0.7 parts by mass of 2-ethyl-4-methylimidazole was prepared, thereby preparing a resin varnish having a resin solid content of 46% by mass.

### Example 1

The resin varnish obtained in Preparation Example 1 was applied onto a release film (a PET film subjected to a release treatment), and dried at 110 degrees Celsius for 300 seconds, thereby producing a PET film with an adhesive resin layer. The thickness of the adhesive resin layer was 36 µm. Two PET films each having the adhesive resin layer were arranged such that the adhesive resin layers faced each other, and a core layer (a polyimide film, thickness: 25 µm) was sandwiched therebetween. Then, bonding was performed with a roll laminator under conditions of an actual peak temperature of 111 degrees Celsius and a roll speed of 0.35 m/min, thereby producing a resin film.

Next, two FR-4 boards (base material thickness: 0.4 mm) each having a test pattern (copper foil thickness: 35 µm) were prepared. The two FR-4 boards were arranged such that the test patterns faced each other. Then, the release films were removed from the obtained resin film, the resin film was sandwiched between the FR-4 boards, and a hot-press treatment was performed, thereby producing a multilayer wiring board. The conditions for the hot-press treatment were 30 minutes at a set temperature of 150 degrees Celsius and a pressure of 0.5 MPa in a first stage, and 70 minutes at a set temperature of 190 degrees Celsius and a pressure of 2 MPa in a second stage.

### Comparative Example 1

A resin film and a multilayer wiring board were produced in the same manner as in Example 1, except that the bonding conditions with the roll laminator were changed to conditions of an actual peak temperature of 95 degrees Celsius and a roll speed of 0.5 m/min.

### Evaluation of Resin Film

Evaluation of the resin film (viscosity of the adhesive resin composition, and blistering after reflow) was performed by the following methods. The obtained results are shown in Table 1.

### (1) Viscosity of Adhesive Resin Composition

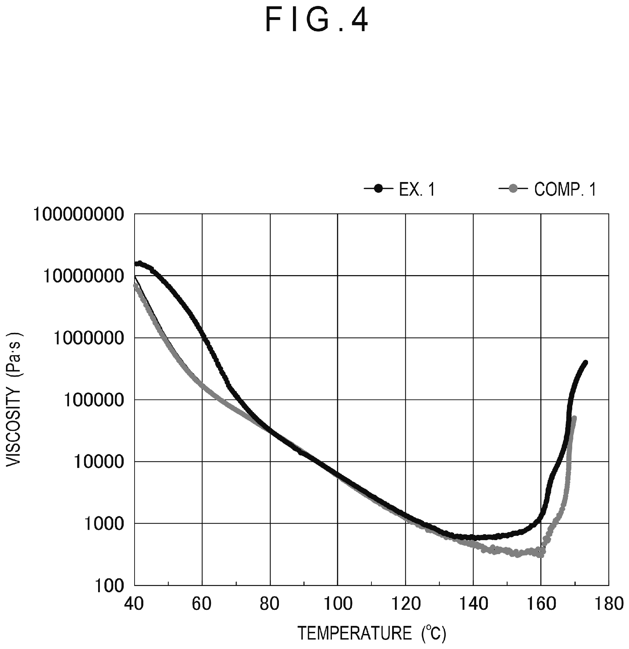

The adhesive resin composition of the adhesive resin layer was collected from the obtained resin film. The collected adhesive resin composition was introduced into a rheometer (device name: "HAAKE MARS III," produced by Thermo Fisher Scientific), and the viscosity of the adhesive resin composition was measured while changing the temperature from 40 degrees Celsius to 170 degrees Celsius under conditions in which the rate of temperature increase was 2.5 degrees Celsius/min and the frequency was 1.0 Hz, with the rotation of the plate being oscillated left and right. The obtained results are shown in Fig. 4.

The minimum viscosity (unit: Pa·s) over a temperature range of 40 degrees Celsius to 160 degrees Celsius and the temperature at that time were read from the graph shown in Fig. 4. In addition, the viscosity (unit: Pa·s) at a temperature of 60 degrees Celsius was read.

### (2) Blistering After Reflow

The obtained multilayer wiring board was placed in a reflow furnace (produced by Tamura Corporation), and a reflow treatment was performed. The reflow conditions were as follows: the preheat temperature was 140 degrees Celsius to 160 degrees Celsius (for about 120 seconds), the period during which the temperature was 220 degrees Celsius or more was about 100 seconds, and the peak temperature was 260 degrees Celsius.

Then, the multilayer wiring board after reflow was observed, and blistering after reflow was evaluated according to the following criteria.
A: No blistering occurred.
C: Blistering occurred.

**Table 1**

| | | Ex. 1 | Comp. 1 |
|---|---|---|---|
| (1) Viscosity of adhesive resin composition | Minimum viscosity (Pa·s) | 576 | 231 |
| | Temperature at which the minimum viscosity is exhibited (°C) | 140 | 160 |
| | Viscosity at 60°C (Pa·s) | 1.1×10⁶ | 1.6×10⁵ |
| (2) Blistering after reflow | | A | C |

As is clear from the results shown in Table 1 and Fig. 4, it was confirmed that, when the minimum viscosity over a temperature range of 40 degrees Celsius to 160 degrees Celsius as measured with a rheometer was 500 Pa·s or more (Example 1), the result of blistering after reflow was favorable.

Accordingly, it was confirmed that the resin film of the invention can prevent interlayer delamination even when a high-temperature heat treatment is performed.

### EXPLANATION OF CODES

- 1: adhesive resin layer
- 1a: cured resin layer
- 1b: coating film
- 2: core layer
- 3: release film layer
- 4: single-layer wiring board
- 41: base material
- 42: wiring
- 100: resin film
- 200: multilayer wiring board

## Claims

1. A resin film comprising:
a core layer; and
adhesive resin layers respectively provided on both surfaces of the core layer, wherein
the adhesive resin layers include an adhesive resin composition, and
a minimum viscosity of the adhesive resin composition, as measured with a rheometer, over a temperature range of 40 degrees Celsius to 160 degrees Celsius is 500 Pa·s or more.

2. The resin film according to claim 1, wherein
the adhesive resin composition contains an epoxy resin, an aromatic amine-based curing agent, and a solvent-soluble polyimide resin.

3. The resin film according to claim 1 or 2, wherein
the core layer is formed of a polyimide film.

4. The resin film according to claim 1 or 2, wherein
a viscosity of the adhesive resin composition, as measured with a rheometer, at a temperature of 60 degrees Celsius is 5×10⁵ Pa·s or more.

5. A multilayer wiring board comprising an insulating layer formed using the resin film according to claim 1 or 2.

6. A copper foil with resin comprising:
the resin film according to claim 1 or 2; and
a copper foil laminated on the resin film.

7. A coil structure comprising an insulating layer formed using the resin film according to claim 1 or 2.

8. A magnetic device comprising an insulating layer formed using the resin film according to claim 1 or 2.
